# EUROPEAN PATENT SPECIFICATION

(11) **EP 2 383 323 B1**
(45) Date of publication and mention of the grant of the patent: **15.02.2017**
(21) Application number: 09836307.0
(22) Date of filing: 10.12.2009
(51) Int. Cl.: H01L 51/54, C09K 11/06, H05B 33/14, H01L 51/50

(54) **NOVEL COMPOUNDS FOR AN ORGANIC PHOTOELECTRIC DEVICE, AND ORGANIC PHOTOELECTRIC DEVICE COMPRISING SAME**
NEUE VERBINDUNGEN FÜR EINE ORGANISCHE PHOTOELEKTRISCHE VORRICHTUNG SOWIE SIE ENTHALTENDE ORGANISCHE PHOTOELEKTRISCHE VORRICHTUNG
NOUVEAUX COMPOSÉS DESTINÉS À UN DISPOSITIF PHOTOÉLECTRIQUE ORGANIQUE, ET DISPOSITIF PHOTOÉLECTRIQUE ORGANIQUE LES COMPRENANT

(30) Priority: 30.12.2008 KR 20080137223
(43) Date of publication of application: 02.11.2011
(73) Proprietor: CHEIL INDUSTRIES INC., Kumi-city Gyeongsangbuk-do 730-030 (KR)
(72) Inventor: IN, Kyu-Yeol, Uiwang-si Gyeonggi-do 437-711 (KR); KANG, Myeong-Soon, Uiwang-si Gyeonggi-do 437-711 (KR); JUNG, Ho-Kuk, Uiwang-si Gyeonggi-do 437-711 (KR); KIM, Nam-Soo, Uiwang-si Gyeonggi-do 437-801 (KR); KANG, Eui-Su, Uiwang-si Gyeonggi-do 437-711 (KR); CHAE, Mi-Young, Uiwang-si Gyeonggi-do 437-711 (KR)
(74) Representative: Michalski Hüttermann & Partner Patentanwälte mbB
(86) International application number: PCT/KR2009/007411
(87) International publication number: WO 2010/076986

(56) References cited:
- WO-A1-2007/026847
- CN-A- 1 833 470
- JP-A- 2004 031 004
- JP-A- 2005 255 986
- JP-A- 2005 268 199
- JP-A- 2005 276 801
- JP-A- 2007 088 433
- KR-A- 20060 114 001

## Description

### [Technical Field]

The present invention relates to a novel compound for an organic photoelectric device and an organic photoelectric device including the same. More particularly, the present invention relates to a compound for an organic photoelectric device being capable of providing an organic photoelectric device having a low driving voltage, and excellent life-span and efficiency characteristics due to excellent hole and electron transport capability and thermal stability, and an organic photoelectric device including the same.

### [Background Art]

An organic photoelectric device transforms electrical energy into light by applying current to an organic light emitting material. It has a structure in which a functional organic thin layer is interposed between an anode and a cathode. The organic thin layer may include an emission layer, a hole injection layer (HIL), a hole transport layer (HTL), an electron transport layer (ETL), an electron injection layer (EIL), and the like, and further include an electron blocking layer or a hole blocking layer to improve light emitting properties of the emission layer.

An organic photoelectric device has similar electrical characteristics to those of light emitting diodes (LEDs) in which holes are injected from an anode and electrons are injected from a cathode, then the holes and electrons move to opposite electrodes and are recombined to form excitons having high energy. The formed excitons generate light having a certain wavelength while shifting to a ground state.

In order to increase the luminous efficiency, smooth combination between holes and electrons in an emission layer is needed. However, since an organic material in general has slower electron mobility than hole mobility, it has a drawback of inefficient combination between holes and electrons resulting in decrease of luminous efficiency. Accordingly, a novel compound that increases electron injection and mobility from a cathode and simultaneously prevents movement of holes is desperately required.

In addition, the device may have a decreased life-span since the material therein may be crystallized due to Joule heat generated when it is driven. In order to solve this problem, 2-(4-biphenylyl)-5-(4-t-butylphenyl)-1,3,4-oxadiazole (PBD) (Jpn. J. Appl. Phys., 27, L269 1988) with a rapid transfer speed has been suggested, but it lacks thermal stability and thereby still has a problem of crystallization when a device is driven. In addition, BCP and an aluminum mixed coordination complex (BAIq, bis(2-methyl-8-quinolinolate)-4-(phenylphenolate)aluminum), which is known to be excellent in lowering hole mobility, have been actively researched. However, these materials have excellent characteristic in lowering hole mobility but a problem of deteriorating the electron injection characteristic and being crystallized when a device is driven, and accordingly do not satisfy device characteristics.

One possible attempt is for instance proposed by JP 2004 031004 A, disclosing an organic electroluminescent element equipped with a light emitting layer containing a host compound and a phosphorescent compound. A 1,3 diazine compound is made contained in either of the layers constituting the element. The substituents of the diazine core denote a hydrogen atom or a univalent substituent, and at least one of them denotes a substituent coupling through a carbon atom, oxygen atom, sulfur atom, or silicon atom.

A further approach is described in JP 2005 276801 A, wherein an electron transportation material is represented by a pyridine with a special formula. In the formula, a ring A is a pyridine cyclic group and two of the substituents are arbitrary substituents. Two other substituents are respectively and independently represent hydrogen atoms or arbitrary substituents. N for representing the number of the ring A is an integer from 1 to 10 and the last substituent Z represents direct connection or a connection group of n-value. However, in the case of n=1, Z is equivalent to an arbitrary substituents for connecting with the ring A. In the case of n>=2, a plurality of substituents included in a molecule may be same or different. In addition, the first substituents and Z do not include any diarylamine skelton.

In addition, WO200522962 A1 provides a charge transporting material having an excellent heat resistance, excellent filming properties, an excellent
charge transporting ability, and excellent light-emitting characteristics and, also, provides an organic electroluminescent element providing a high luminance and a highly luminous efficiency and having a long life. The invention relates to a charge transporting material comprising a compound having within the molecule two or more pyridine rings substituted at 2-, 4- and 6-positions thereof, which rings do not substantially conjugate each other (provided that the 3- and 5-positions of the pyridine rings may be substituted) and an organic electroluminescent element using the charge transporting material.

CN 1833470 A similarly provides a material with excellent properties

Therefore, there is a strong need for an organic compound having excellent electron injection and mobility, and high thermal stability in order to improve efficiency and life-span characteristics of an organic light emitting diode.

### [Disclosure]

### [Technical Problem]

One embodiment of the present invention provides a compound for an organic photoelectric device having excellent hole and electron transport capability.

Another embodiment of the present invention provides an organic photoelectric device having a low driving voltage, and excellent life-span and efficiency characteristics by including the compound for an organic photoelectric device.

Yet another embodiment of the present invention provides a display
device including the organic photoelectric device is provided.

The embodiments of the present invention are not limited to the above technical purposes, and a person of ordinary skill in the art can understand other technical purposes.

### [Technical Solution]

The solution to the technical problem is provided by the subject matter of claim 1.

Hereinafter, further embodiments of the present invention will be described in detail.

### [Advantageous Effects]

The compound for an organic photoelectric device according to one embodiment has improved hole and electron transport capability by adjusting its energy level through substituent adjustment. Particularly, the compound for an organic photoelectric device has a structure where an aryl group and a heterocyclic group are sequentially repeated lowers an energy level resulting in improvement of electron transport capability. Thereby, the compound for an organic photoelectric device according to one embodiment may be an organic thin layer of an emission layer, a hole transport layer (HTL), a hole injection layer (HIL), an electron transport layer (ETL), an electron injection layer (EIL), or a combination thereof, and provides organic photoelectric device having excellent electrochemical and thermal stability and life-span, and high luminous efficiency at a low driving voltage.

### [Description of Drawings]

FIGS. 1 to 5 are cross-sectional views showing organic photoelectric devices including organic compounds according to various embodiments of the present invention.
FIG. 6 shows a ¹H NMR spectrum of the compound according to Example 1 of the present invention.
FIG. 7 shows a ¹H NMR spectrum of the compound according to Example 2 of the present invention.
FIG. 8 shows a ¹H NMR spectrum of the compound according to Example 3 of the present invention.
FIG. 9 shows voltage-current density characteristics of the organic light emitting diodes according to Examples 4 to 6 and Comparative Example 1.

### <Description of Reference Numerals Indicating Primary Elements in the Drawings>

100 : organic photoelectric device : cathode
120 : anode : organic thin layer
130 : emission layer: hole transport layer (HTL)
150 : electron transport layer (ETL) : electron injection layer (EIL)
170 : hole injection layer (HIL) : emission layer + electron transport layer (ETL)

### [Mode for Invention]

Exemplary embodiments of the present invention will hereinafter be described in detail. However, these embodiments are only exemplary, and the present invention is not limited thereto.

As used herein, when a definition is not otherwise provided, the term "alkyl" may refer to a C1 to C50 alkyl, and preferably a C1 to C15 alkyl, the term "alkoxy" may refer to a C1 to C50 alkoxy, and preferably C1 to C15 alkoxy, the term "alkenyl" may refer to a C2 to C50 alkenyl, and preferably C2 to C15 alkenyl the term "cycloalkyl" may refer to a C3 to C50 cycloalkyl, and preferably a C3 to C15 cycloalkyl, the term "aryl" may refer to a C6 to C50 aryl, and preferably C6 to C25 aryl, and the term "heterocyclic group" may refer to a C1 to C50 heterocyclic group, and preferably C1 to C25 heterocyclic group.

In particular, as used herein, when a definition is not otherwise provided, the term "heterocyclic group" may refer to a C3 to C50 heteroaryl group, a C1 to C50 heterocycloalkyl group, a C1 to C50 heterocycloalkenyl group, a C1 to C50 heterocycloalkynyl group, or a fused cyclic group thereof, which includes a heteroatom. The heterocyclic group may include 1 to 20 heteroatoms, and particularly 1 to 15 heteroatoms.

As used herein, when a definition is not otherwise provided, the term "ester" may refer to COOR, and the term "carbonyl" may refer to -COR'. Herein, R and R' are each independently hydrogen, a C1 to C10 alkyl group, a C6 to 20 aryl group, a C3 to C20 cycloalkyl group, a C2 to C10 alkenyl group, a C2 to C10 alkynyl group, or a combination thereof.

As used herein, when specific definition is not otherwise provided, the term "substitutent" may refer to a halogen, a nitrile group, cyano group, nitro group, amide group, carbonyl group, ester group, C1 to C10 alkyl group, C1 to C10 alkoxy group, C2 to C10 alkenyl group, C2 to C10 alkynyl group, C3 to C10 cycloalkyl group, or C6 to C20 aryl group.

As used herein, when specific definition is not otherwise provided, the term "heteroatom" may refer to one selected from N, O, S, P, Se, and Si.

As used herein, when specific definition is not otherwise provided, the prefix "hetero" may refer to one including 1 to 3 heteroatoms, and remaining carbons in one ring.

A compound for an organic photoelectric device according to one embodiment may be a compound represented by the following Chemical Formula 2.

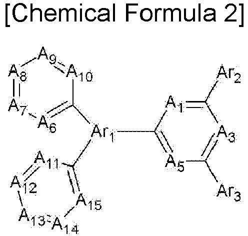

In Chemical Formula 2,
A₁, A₃, A₅, A₆ to A₁₅ are the same or different and are independently selected from the group consisting of CR₁, CR₃, CR₅, CR₆ to CR₁₅, SiR₁, SiR₃, SiR₅, SiR₆, to SiR₁₅, and N, wherein the adjacent R₆ to R₁₀ are optionally fused to each other to form a fused ring, or the adjacent R₁₁ to R₁₅ are optionally fused to each other to form a fused ring,
provided that, at least one of A₁, A₃ and A₅ is selected from the group consisting of SiR₁, SiR₃, SiR₅ and N, at least one of
A₆ to A₁₀ is selected from the group consisting of SiR₆ to SiR₁₀ and N; or at least one of atom of a fused ring formed by the adjacent R₆ to R₁₀ is a heteroatom, and at least one of A₁₁ to A₁₅ is selected from the group consisting of SiR₁₁ to SiR₁₅ and N; or at least one of atom of a fused ring formed by the adjacent R₁₁ to R₁₅ is a heteroatom,
R₁, R₃, R₅, R₆ to R₁₅ are the same or different, and are each independently selected from the group consisting of hydrogen, a halogen, a nitrile group, a cyano group, a nitro group, an amide group, a carbonyl group, ester group, a substituted or unsubstituted alkyl group, a substituted or unsubstituted alkylene group, a substituted or unsubstituted alkoxy group, a substituted or unsubstituted alkenyl group, a substituted or unsubstituted alkenylene group, a substituted or unsubstituted alkynyl group, a substituted or unsubstituted alkynylene group, a substituted or unsubstituted cycloalkyl group, a substituted or unsubstituted cycloalkylene group, a substituted or unsubstituted aryl group, and a substituted or unsubstituted arylene group,
Ar₁ is a substituted or unsubstituted arylene group, and
Ar₂ and Ar₃ are the same or different and are independently a substituted or unsubstituted aryl group.

Preferably, at least one of A₁, A₃ and A₅ includes N, at least one of A₆ to A₁₀ includes N, and at least one of A₁₁ to A₁₅ includes N.

When Ar₁ is a substituted or unsubstituted arylene group, Ar₂ and Ar₃ are the same or different and are independently a substituted or unsubstituted aryl group, and the aryl is C6 to C50 aryl which is a monocyclic aryl such as phenyl, or a polycyclic aryl such as naphthyl, anthracenyl, phenanthrenyl, pyrenyl, peryenyl, and the like, the compound may be useful to an emission layer for a organic photoelectric device.

When R₁ to R₁₀ of Chemical Formula 1 and R₁, R₃, R₅, R₆ to R₁₅ of Chemical Formula 2 is a substituted or unsubstituted aryl group, or a substituted or unsubstituted arylene group, the aryl may be C6 to C50 aryl. Particularly, when the aryl is a monocyclic aryl such as phenyl, biphenyl, terphenyl, styrenyl, and the like, or a polycyclic aryl naphthyl, anthracenyl, phenanthrenyl, pyrenyl, peryenyl, pyrenyl, and the like the compound may be useful to an emission layer for a organic photoelectric device.

In Chemical Formula 1, the adjacent R₁ to R₅ may be fused to each other to form a fused ring, and the adjacent R₆ to R₁₀ may be fused to each other to form a fused ring. In Chemical Formula 2, the adjacent R₆ to R₁₀ may be fused to each other to form a fused ring, and the adjacent R₁₁ to R₁₅ may be fused to each other to form a fused ring. Herein, a fused ring including A₁ to A₅ and a fused ring including A₆ to A₁₀, in Chemical Formula 1, and a fused ring including A₆ to A₁₀ and a fused ring including A₁₁ to A₁₅ in Chemical Formula 2 may be a substituted or unsubstituted heterocyclic group.

The heterocyclic group may be selected from the group consisting of a thiophenyl group, a furanyl group, a pyrrolyl group, an imidazolyl group, a thiazolyl group, an oxazolyl group, an oxadiazolyl group, a triazoly group, a carbazolyl group, a pyridinyl group, pyridazine group, a quinolinyl group, isoquinolinyl group, an arcidyl group, an imidazopyridinyl group and imidazopyrimidinyl group.

Particularly, a substituent linked to nitrogen (N) of the imidazolyl or triazolyl group is selected from the group of an alkyl group such as a substituted or unsubstituted methyl group, ethyl group, propyl group, isopropyl group, butyl group, tertiary-butyl group, pentyl group, hexyl group, heptyl group, and the like; a cycloalkyl group such as a substituted or unsubstituted cyclopentyl group, a cyclohexyl group, and the like; an aryl group such as a substituted or unsubstituted phenyl group, biphenyl group, naphthyl group, and the like; and a substituted or unsubstituted heterocyclic group. The heterocyclic group is preferably a heteroaryl group such as pyridyl, bipyridyl, quinolyl, isoquinolyl, and the like.

The various substituents of the above-described compound represented by the above Chemical Formula 1 and Chemical Formula 2 does not change principal properties of the compound for an organic photoelectric device according to one embodiment.

Examples of the compounds for an organic photoelectric device according to one embodiment of the present invention include the compounds represented by the following Formulae 18 to 52, but are not limited thereto.

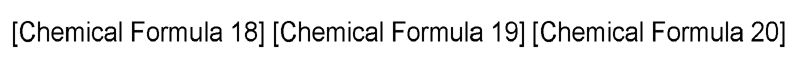

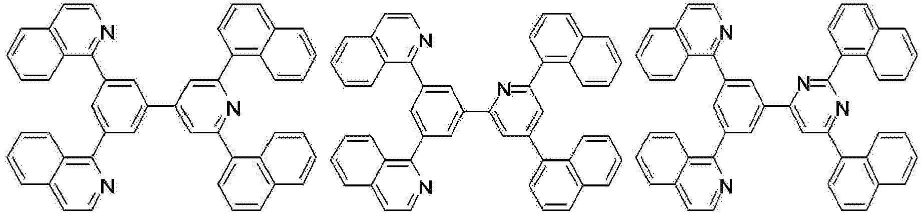

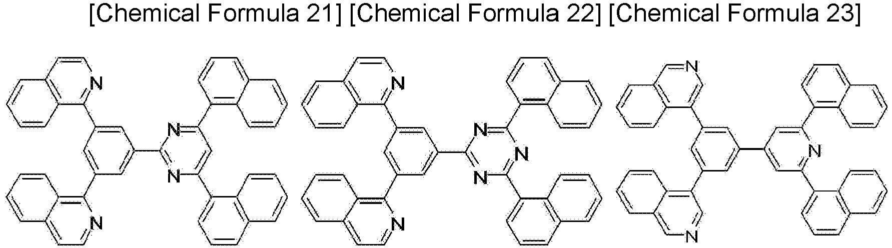

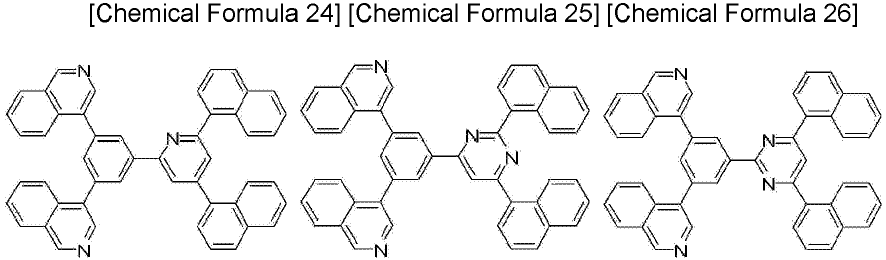

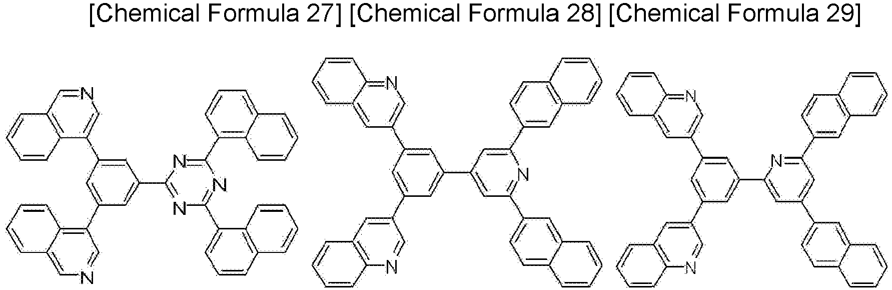

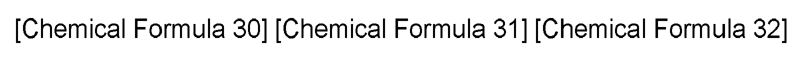

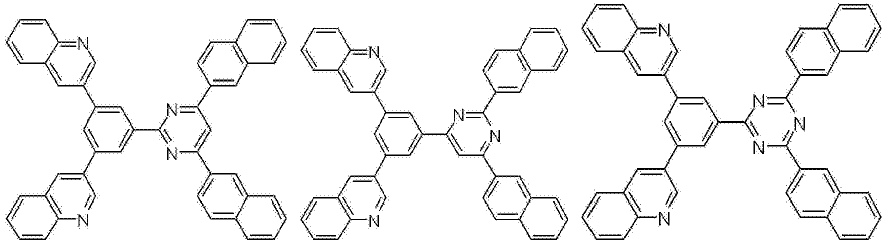

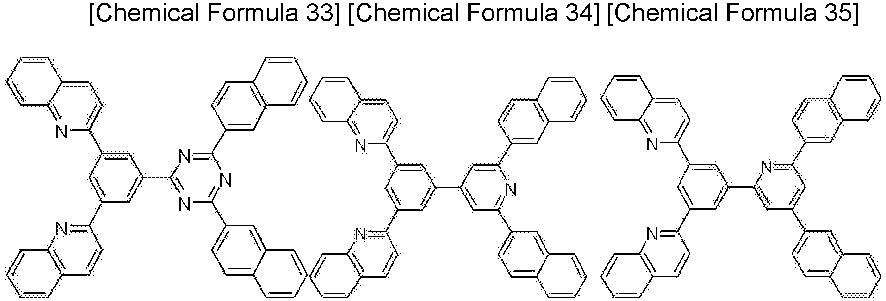

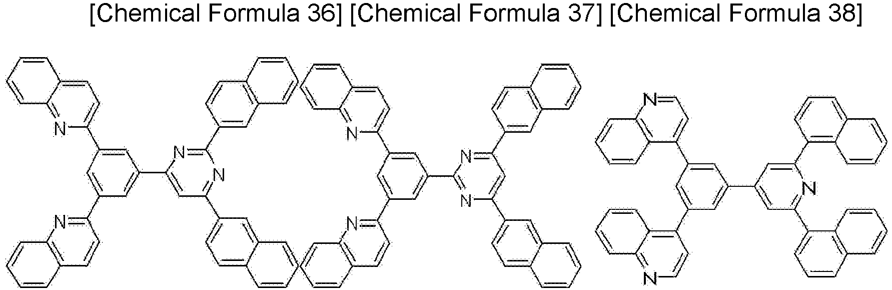

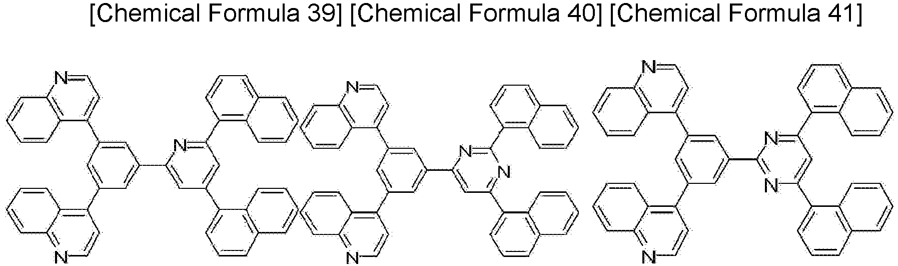

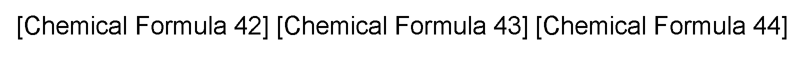

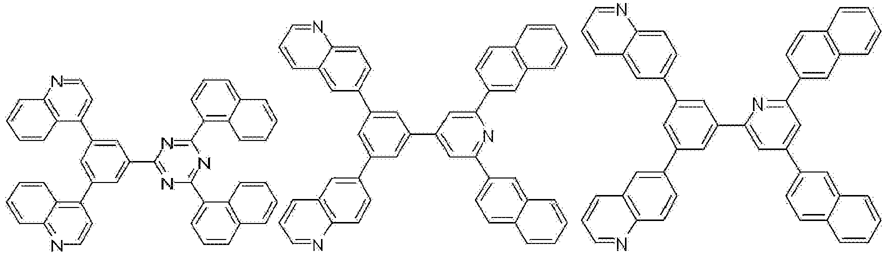

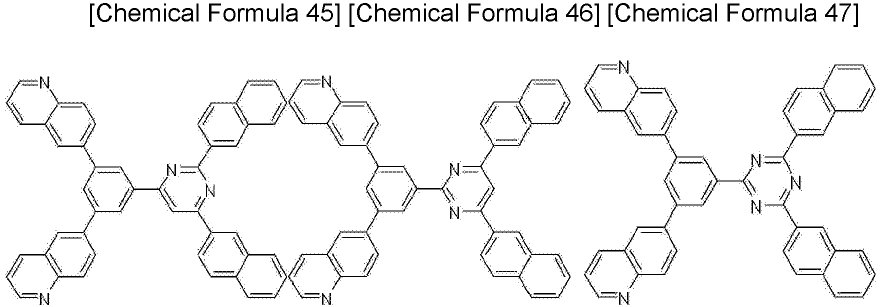

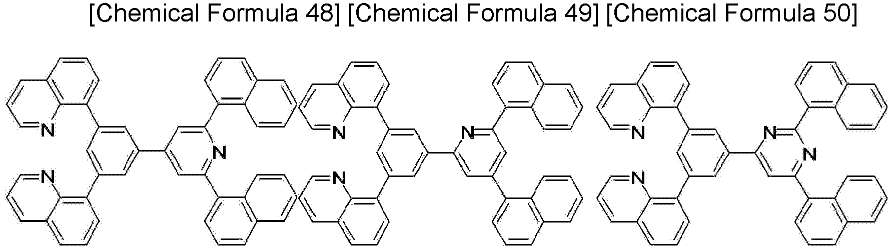

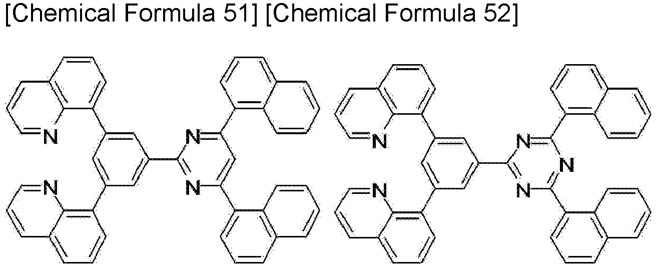

The compound for an organic photoelectric device including the above compounds can act as a light emitting host with an appropriate dopant due to good hole and electron transport capability. Particularly, the dopant may be a reducing dopant. The reducing dopant may be selected from the group consisting of an alkali metal, an alkali earth metal, a rare earth element metal, an oxide of an alkali metal, a halide of an alkali metal, an organic complex of an alkali metal, an oxide of an alkali earth metal, a halide of an alkali earth metal, an organic complex of an alkali earth metal, an oxide of an alkali earth metal, a halide of an alkali earth metal, an organic complex of an alkali earth metal, an oxide of a rare earth element metal, a halide of a rare earth element metal, and an organic complex of a rare earth element metal.

The compound for an organic photoelectric device is applied to an organic thin layer of an organic photoelectric device, and thus provides an organic photoelectric device having improved efficiency and a low driving voltage. Also, life-span of the organic photoelectric device may be improved.

Another embodiment provides an organic photoelectric device including the compound for an organic photoelectric device. Such an organic photoelectric device includes an organic light emitting diode (OLED), an organic solar cell, an organic photo conductor drum, an organic transistor, an organic memory device, and the like. Particularly, the compound for an organic photoelectric device according to one embodiment may be applied to an electrode or an electrode buffer layer of an organic solar cell to improve quantum efficiency, or may be applied to an electrode material of a gate, source-drain electrodes, and the like of an organic transistor.

Hereinafter, an organic photoelectric device is illustrated in more detail.

According to another embodiment of the present invention, an organic photoelectric device including anode and cathode, and at least one organic thin layer disposed between the anode and cathode is provided. The organic thin layer includes the compound for an organic photoelectric device according to one embodiment.

The compound for an organic photoelectric device may be included in an organic thin layer that includes at least one of an emission layer, a hole transport layer (HTL), a hole injection layer (HIL), a hole blocking layer, an electron transport layer (ETL), an electron injection layer (EIL), an electron blocking layer, or a combination thereof. At least one of these organic thin layer includes the compound for an organic photoelectric device. Particularly, at least one of layer of an emission layer, a hole transport layer (HTL), a hole injection layer (HIL), an electron transport layer (ETL), an electron injection layer (EIL), or a combination thereof may include the compound for an organic photoelectric device according to one embodiment.

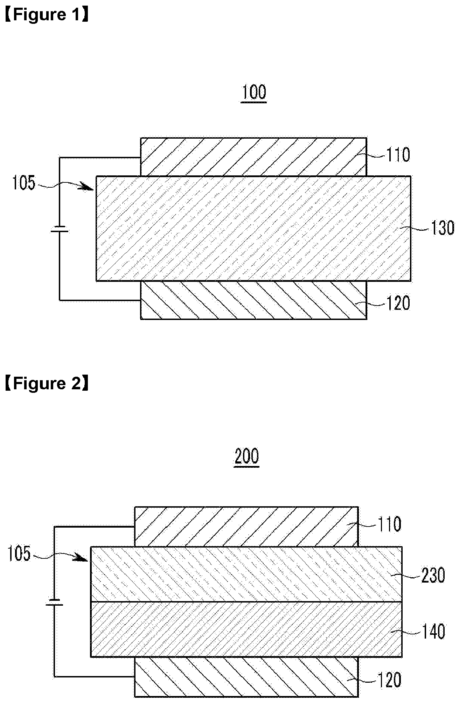

FIGS. 1 to 5 are cross-sectional views showing organic light emitting diodes including the novel organic compounds according to various embodiments of the present invention.

Referring to FIGS. 1 to 5, the organic photoelectric devices 100, 200, 300, 400, and 500 according to one embodiment includes at least one organic thin layer 105 interposed between an anode 120 and a cathode 110.

The anode 120 includes an anode material laving a large work function to help hole injection into an organic thin layer. The anode material includes a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:Al or SnO₂:Sb; or a conductive polymer such as poly(3-methylthiophene), poly[3,4-(ethylene-1,2-dioxy)thiophene] (PEDT), polypyrrole, and polyaniline, but is not limited thereto.

The cathode 110 includes a cathode material having a small work function to help electron injection into an organic thin layer. The cathode material includes a metal such as magnesium, calcium, sodium, potassium, titanium, indium, yttrium, lithium, gadolinium, aluminum, silver, tin, and lead, or alloys thereof; or a multi-layered material such as LiF/Al, Liq/Al, LiO₂/Al, LiF/Ca, LiF/Al, and BaF₂/Ca, but is not limited thereto.

Referring to FIG. 1, the organic photoelectric device 100 includes an organic thin layer 105 including only an emission layer 130.

Referring to FIG. 2, a double-layered organic photoelectric device 200 includes an organic thin layer 105 including an emission layer 230 including an electron transport layer (ETL), and a hole transport layer (HTL) 140. The emission layer 130 also functions as an electron transport layer (ETL), and the hole transport layer (HTL) 140 layer has an excellent binding property with a transparent electrode such as ITO or an excellent hole transporting property.

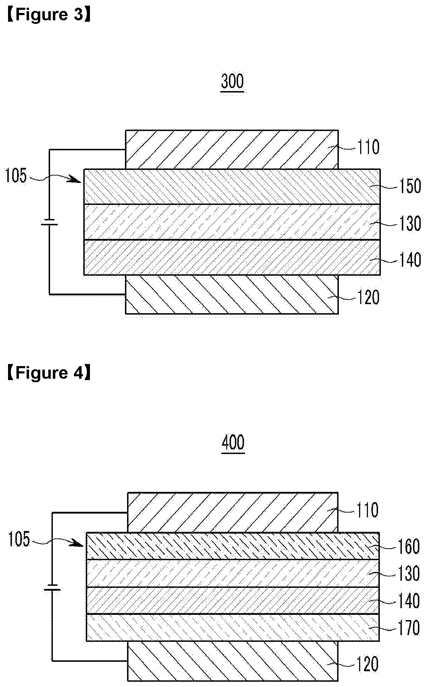

Referring to FIG. 3, a three-layered organic photoelectric device 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

As shown in FIG. 4, a four-layered organic photoelectric device 400 includes an organic thin layer 105 including an electron injection layer (EIL) 160, an emission layer 130, a hole transport layer (HTL) 140, and a hole injection layer (HIL) 170 for binding with the cathode of ITO.

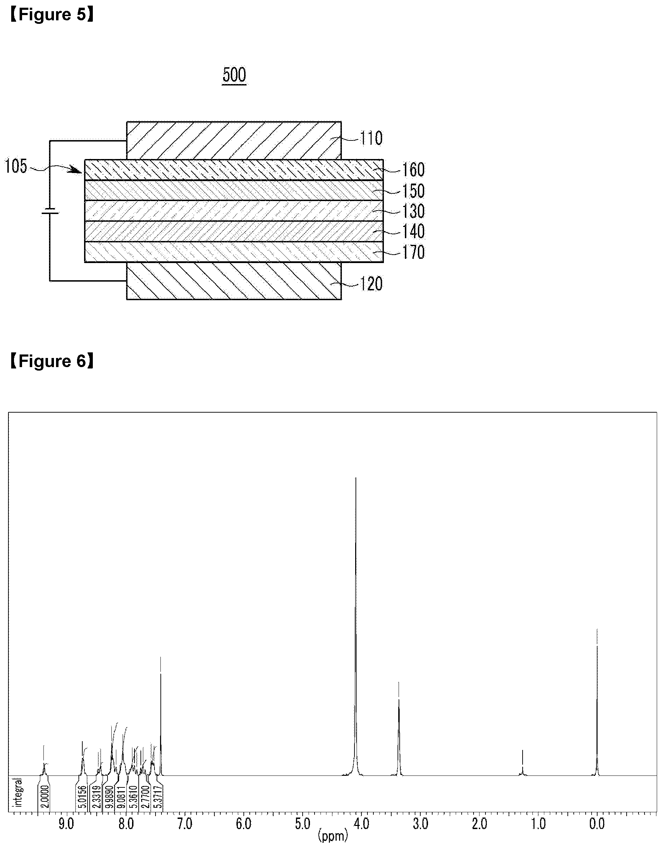

As shown in FIG. 5, a five layered organic photoelectric device 500 includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

The light emitting diode may be fabricated by forming an anode on a substrate, forming an organic thin layer, and forming a cathode thereon. The organic thin layer can be formed by a dry coating method such as evaporation, sputtering, plasma plating, and ion plating, or a wet coating method such as spin coating, dipping, and flow coating.

Another embodiment of the present invention provides a display device including the organic photoelectric device according to the above embodiment.

Hereinafter, the embodiments are illustrated in more detail with reference to examples. However, the following are exemplary embodiments and are not limiting.

### Synthesis of compound for an organic photoelectric device

### Example 1: Synthesis of compound of Chemical Formula 28

A compound represented by the above Chemical Formula 28, which was suggested as a specific example of a compound for an organic photoelectric device according to one embodiment of the present invention was synthesized through four steps as provided in the following Reaction Scheme.

### Synthesis of an intermediate product (A) in a first step

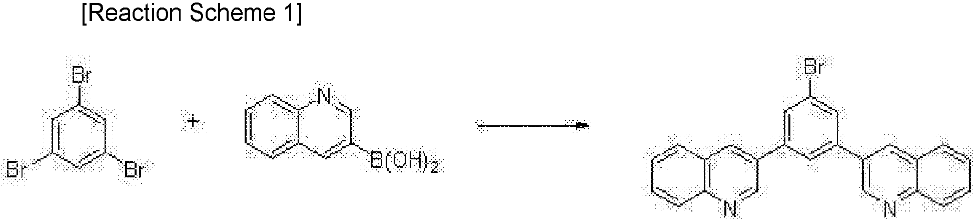

20 g (63.5 mmol) of tribromobenzene, 24.2 g (139.8 mmol) of quinoline-3-boronic acid, 7.4 g (6.4 mmol) of tetrakis(triphenylphosphine)palladium 0, and 52.7 g (381.2 mmol) of potassium carbonate were dissolved in 800 ml of a solvent prepared by mixing tetrahydrofuran/H₂O in a volume ratio of 3/1 and then, reacted at 85 °C for 18 hours. The obtained reactant was extracted with ethyl acetate, and then, the solvent was removed under a reduced pressure. The extracted product was separated using a column and dried, obtaining 13 g (Y=50 %) of a solid.

### Synthesis of intermediate product (B) in a second step

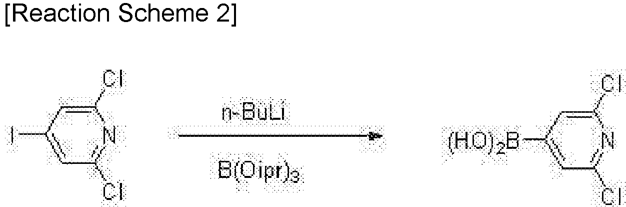

10 g (36.5 mmol) of 2-6-dibromo-4-iodopyridine was dissolved in 500 ml of tetrahydrofuran. Then, the solution was maintained at 78 °C. Then, 22.8 ml (36.51 mmol) of a 1.6 M n-butyl lithium solution was slowly dropped to the above solution. The mixture was agitated at 78 °C for one hour. Next, 10.1 ml (43.8 mmol) of triisopropyl borate was added to the agitated mixture. The resulting mixture was slowly heated to room temperature and reacted for 18 hours while agitated. To the reaction mixture, a sodium hydroxide aqueous solution was added. The mixture was agitated for one hour, and then, hydrochloric acid was used to adjust acidity of the entire solution into neutral. Then, the reactant was extracted using ethyl acetate, and the solvent was removed under a reduced pressure, separated using a column, and dried, obtaining a solid of 2.83 g (Y=40 %).

### Synthesis of intermediate product (C) in a third step

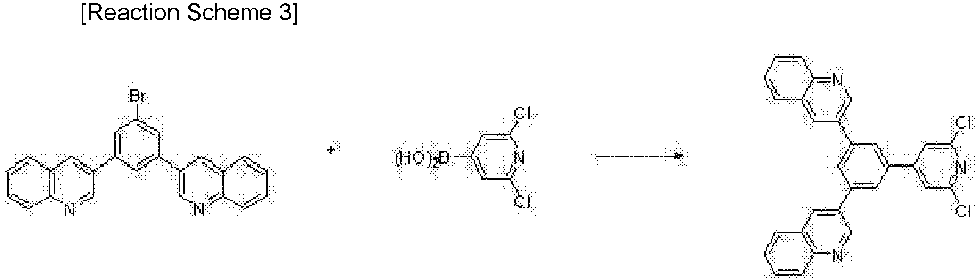

4.81 g (11.7 mmol) of the intermediate product (A) obtained in the first step, 2.21 g (11.52 mmol) of the intermediate (B) obtained in the second step, 1.26 g (1.1 mmol) of tetrakis(triphenyl-phosphine)palladium 0, and 4.52 g (32.7 mmol) of potassium carbonate were dissolved in 180 ml of a solvent prepared by mixing tetrahydrofuran/H₂O in a volume ratio of 3/1. The solution was reacted at 75 °C for 18 hours. The obtained reactant was extracted using ethylacetate, separated using a column after removing the solvent under a reduced pressure, and dried, obtaining a solid of 3.74 g (Y=68 %).

### Synthesis of compound of Chemical Formula 28 in a fourth step

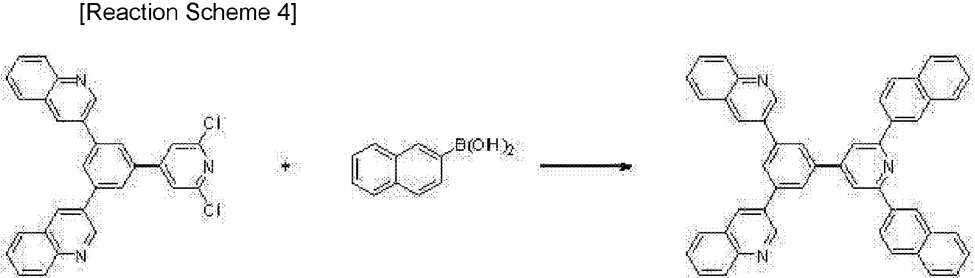

3.74 g (7.82 mmol) of intermediate product (C) obtained in the step 3, 2.96 g (17.2 mmol) of naphthalene-2-boronic acid, 0.9 g (0.78 mmol) of tetrakis(triphenylphosphine)palladium 0, and 6.48 g (46.9 mmol) of potassium carbonate were dissolved in 160 ml of a solvent prepared by mixing tetrahydrofuran/H₂O in a volume ratio of 3/1. The solution was reacted at 85 °C for 3 hours. The resulting reactant was extracted using chloroform, separated using a column after removing the solvent under a reduced pressure, and dried, obtaining a solid of 2 g (Y=39 %).

### Example 2: Synthesis of compound of Chemical Formula 30

A compound represented by the above Chemical Formula 30 as suggested as a specific example of a compound for an organic photoelectric device was synthesized through three steps in the following Reaction Scheme.

### Synthesis of intermediate product (D) in a first step

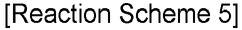

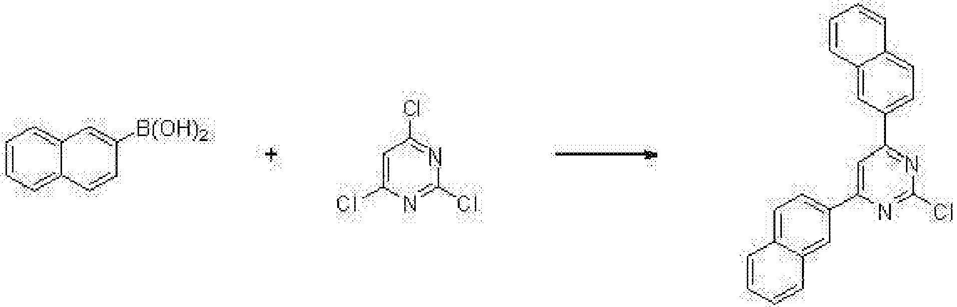

20 g (109.04 mmol) of 2,4,6-trichloropyrimidine, 37.5 g (218.04 mmol) of naphthalene-2-boronic acid, 6.3 g (5.45 mmol) of tetrakis(triphenylphosphine)palladium 0, and 60.3 g (436.29 mmol) of potassium carbonate were dissolved in 600 ml of a solvent prepared by mixing tetrahydrofuran/H₂O in a volume ratio of 2/1. The solution was reacted at 80 °C for 6 hours. The resulting reactant was extracted using chloroform, separated using a column after removing the solvent under a reduced pressure, and dried, obtaining a solid of 29.5 g (Y=74 %).

### Synthesis of an intermediate product (E) in a second step

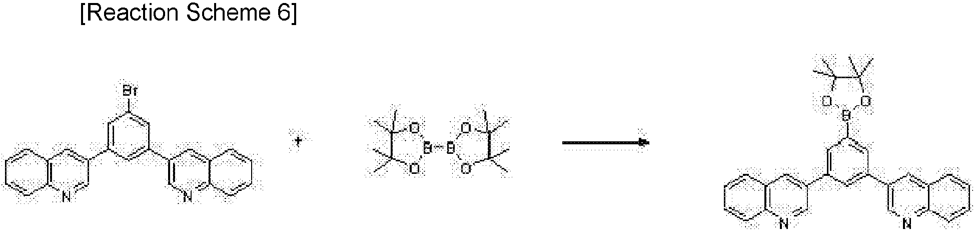

21.11 g (51.33 mmol) of the intermediate product (A), 15.64 g (61.59 mmol) of bis(pinacolato)diborone, 2.1 g (2.57 mmol) of [1,1'-bis(diphenylphosphino)ferrocene]dichloro palladium (II) complex with dichloromethane, 15.1 g (153.98 mmol) of potassium acetate were dissolved in 500 ml of toluene. The solution was heated at 80 °C for 18 hours. The resulting reactant was extracted using chloroform, separated using a column after removing the solvent under a reduced pressure, and dried, obtaining a solid of 21.9 g (Y=96 %).

### Synthesis of compound of Chemical Formula 30 in a third step

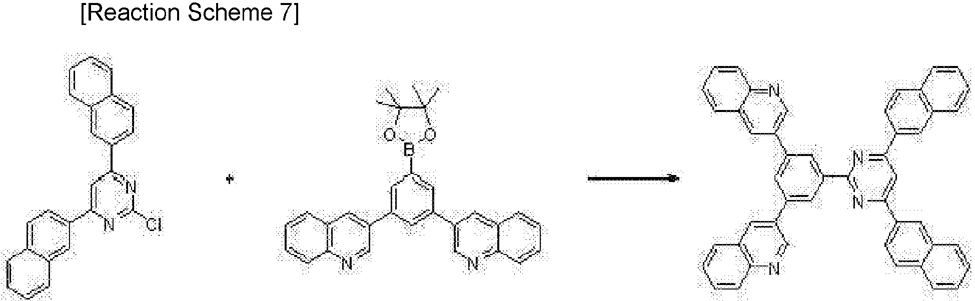

3 g (8.18 mmol) of the intermediate product (D) prepared in the first step , 3.29 g (7.44 mmol) of the intermediate product (E) prepared in the second step, 0.43 g (0.37 mmol) of tetrakis(triphenylphosphine)palladium 0, and 3.08 g (22.3 mmol) of potassium carbonate were dissolved in 120 ml of a solvent prepared by mixing tetrahydrofuran/H₂O in a volume ratio of 3/1. The solution was reacted at 85 °C for 18 hours. The resulting reactant was extracted using chloroform, separated using a column after removing the solvent under a reduced pressure, and then, dried, obtaining a solid of 3.5 g (Y=70 %).

### Example 3: Synthesis of compound of Chemical Formula 31

A compound represented by the above Chemical Formula 31 as a specific example of a compound for an organic photoelectric device was synthesized through two steps provided in the following Reaction Scheme.

### Synthesis of an intermediate product (F) in a first step

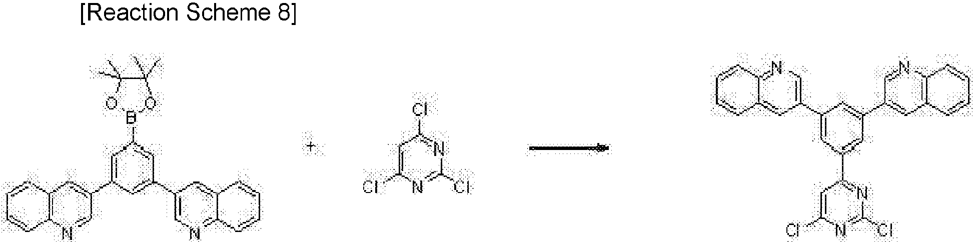

6 g (13.09 mmol) of the intermediate product (F), 2.4 g (13.09 mmol) of 2,4,6-Trichloropyrimidine, 0.38 g (0.33 mmol) of tetrakis(triphenylphosphine)palladium 0, and 3.62 g (26.19 mmol) of potassium carbonate were dissolved in 72 ml of a solvent prepared by mixing tetrahydrofuran/H₂O in a volume ratio of 2/1. The solution was reacted at 80 °C for 6 hours. The resulting reactant was extracted using chloroform, separated using a column after removing the solvent under a reduced pressure, and then, dried, obtaining a solid of 4.9 g (Y=78 %).

### Synthesis of compound of Chemical Formula 31 in a second step

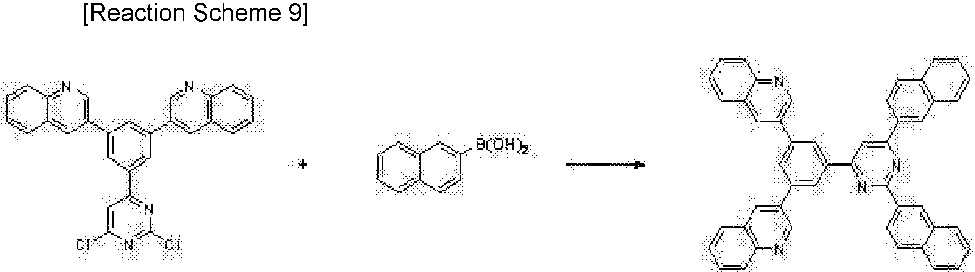

4.9 g (10.22 mmol) of the intermediate product (F) prepared in the first step, 3.9 g (22.68 mmol) of naphthalene-2-boronic acid, 0.6 g (0.52 mmol) of tetrakis(triphenylphosphine)palladium 0, and 5.7 g (41.24 mmol) of potassium carbonate were dissolved in 350 ml of a solvent prepared by mixing tetrahydrofuran/H₂O/toluen in a volume ratio of 3/2/2. The solution was reacted at 110 °C for 24 hours. The resulting reactant was extracted using chloroform, separated using a column after removing the solvent under a reduced pressure, and then, dried, obtaining a solid of 3.9 g (Y=58 %).

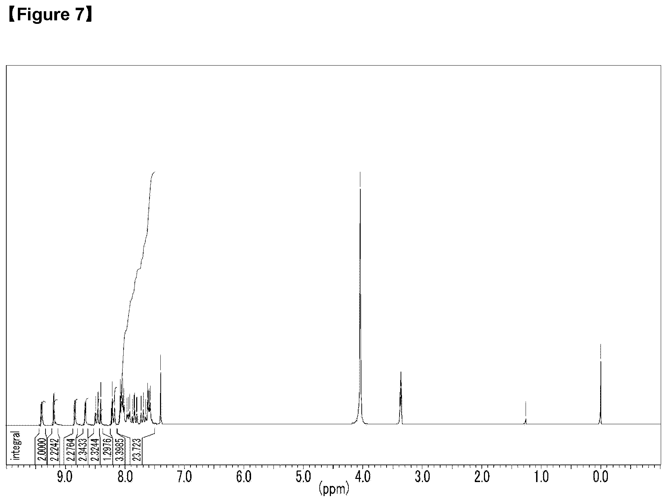

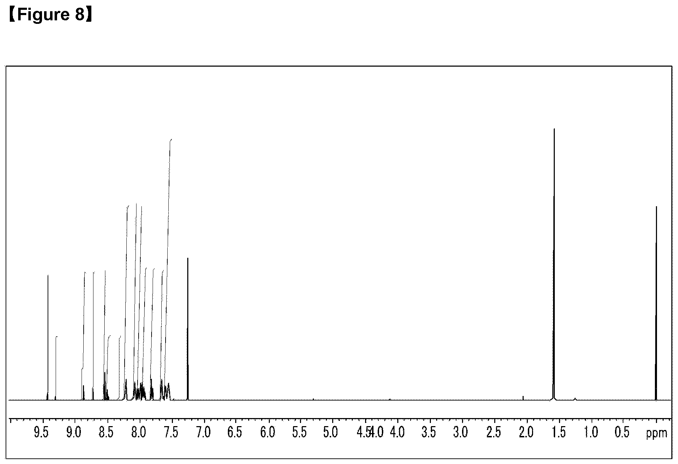

The compounds synthesized according to Examples 1 to 3 were analyzed using ¹H NMR (nuclear magnetic resonance spectroscopy). The results are respectively provided in FIGS. 6 to 8.

### Fabrication of organic light emitting diode

### Example 4

A positive electrode was fabricated by cutting a 15 Ω/cm₂ 1200Å ITO glass substrate (Corning Inc.) to have a size of 50 mm x 50 mm xmm and cleaned with an ultrasonic wave in isopropyl alcohol and pure water respectively for 5 minutes and then and with UV-ozone for 30 minutes.

Then, thermal vacuum-deposition was performed on the glass substrate under vacuum degrees of 65010-7 Pa. First of all, an N1,N1'-(biphenyl-4,4'-diyl)bis
(N1-(naphthalene-2-yl)-N4,N4-diphenylbenzene-1,4-diamine (65nm) hole injection layer (HIL) was deposited, and then, an N,N'-di (1-naphthyl)-N,N'-diphenylbenzidine (NPB) (40 nm) hole transport layer (HTL) was deposited thereon.

Then, an emission layer (25 nm) prepared by mixing 5 wt% of N,N,N',N'-tetrakis (3,4-dimethylphenyl)chrysene-6,12-diamine and 95 wt% of 9-(3-(naphthalene-1-yl)phenyl)-10-(naphthalene-2-yl)anthracene was deposited thereon, an electron transport layer (ETL) prepared by using the compound (35 nm) according to Example 1 was deposited.

On the electron transport layer (ETL), Liq as an electron injection layer (EIL) was vacuum-deposited to be 0.5 nm thick under the same deposit condition, and Al was vacuum-deposited to be 100 nm thick to form a Liq/Al electrode. The organic light emitting diode has a structure as shown in FIG. 5.

### Example 5

An organic light emitting diode was fabricated according to the same method as in Example 4 except for using the compound according to Example 2 for an electron transport layer (ETL).

### Example 6

An organic light emitting diode was fabricated according to the same method as in Example 4 except for using the compound according to Example 3 for an electron transport layer (ETL).

### Comparative Example 1

An organic light emitting diode was fabricated according to the same method as in Example 4 except for using Alq₃ as an electron transport material to form an electron transport layer (ETL).

### Property measurement and analysis

### 1) Measurement of driving voltage, luminance, luminous efficiency, and color coordinate

The organic light emitting diodes according to Examples 4 to 6 and Comparative Example 1 were measured regarding driving voltage (V) and color coordinate to emit luminance of 1000 cd/m² by using a luminance meter (Minolta Cs-1000A) and regarding current efficiency (cd/A) and electrical power efficiency (Im/W) to emit the same luminance. The results are provided in Table 1.

### 2) Current density measurement depending on voltage change

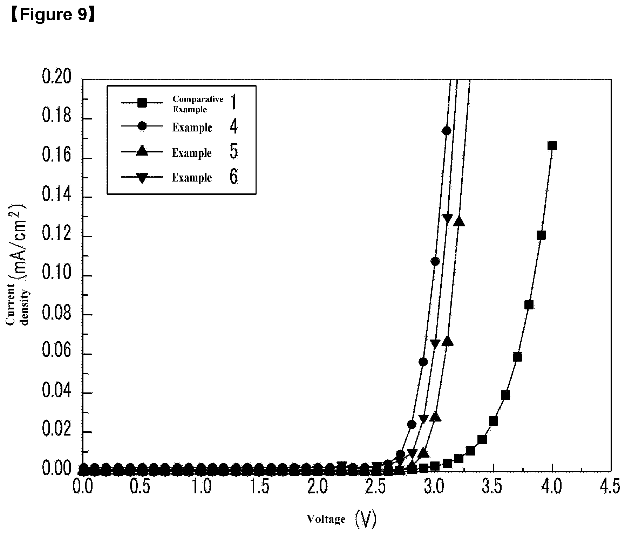

Each organic light emitting diode according to Examples 4 to 6 and Comparative Example 1 was measured regarding current in a unit device by using a current-voltage device (Keithley 2400) while increasing its voltage from 0 V to 14 V. The current measurement was divided by an area to calculate current density. The result is provided in FIG. 9.

**Table 1**

| | Luminance at 1000 cd/m² | | | Color coordinate CIE | |
|---|---|---|---|---|---|
| | Driving voltage(V) | Current efficiency (cd/A) | Electrical power efficiency (Im/W) | x | y |
| Example 4 | 5.68 | 11.82 | 6.54 | 0.13 | 0.26 |
| Example 5 | 5.87 | 9.43 | 5.04 | 0.14 | 0.22 |
| Example 6 | 5.63 | 9.66 | 5.39 | 0.14 | 0.22 |
| Comparative Example 1 | 7.30 | 6.85 | 2.95 | 0.13 | 0.22 |

Referring to Table 1 and to FIG. 9, the organic light emitting diodes according to Examples 4 to 6 had remarkably lower driving voltage than the one of Comparative Example 1. In addition, the organic light emitting diodes according to Examples 4 to 6 had remarkably low driving voltage but superbly high current efficiency and electric power efficiency.

These measurement results come from balance between holes and electrons in the emission layer. The compounds used in Examples 4 to 6 had excellent electron implant and transport characteristics compared with an electron transport material, Alq₃.

## Claims

1. A compound for an organic photoelectric device, wherein the compound for an organic photoelectric device is represented by the following Chemical Formula 2: 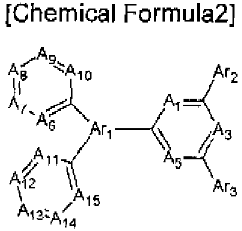 wherein, in Chemical Formula 2,
A₁, A₃, A₅, A₆ to A₁₅ are the same or different and are independently selected from the group consisting of CR₁, CR₃, CR₅, CR₆ to CR₁₅, SiR₁, SiR₃, SiR₆, SiR₆, to SiR₁₅, and N, wherein the adjacent R₆ to R₁₀ are optionally fused to each other to form a fused ring, or the adjacent R₁₁ to R₁₅ are optionally fused to each other to form a fused ring,
provided that, at least one of A₁, A₃ and A₅ is selected from the group consisting of SiR₁, SiR₃, SiR₅ and N, at least one of A₆ to A₁₀ is selected from the group consisting of SiR₆ to SiR₁₀ and N; or at least one of atom of a fused ring formed by the adjacent R₆ to R₁₀ is a heteroatom, and at least one of A₁₁ to A₁₅ is selected from the group consisting of SiR₁₁ to SiR₁₅ and N; or at least one of atom of a fused ring formed by the adjacent R₁₁ to R₁₅ is a heteroatom,
R₁, R₃, R₅, Re to R₁₅ are the same or different, and are each independently selected from the group consisting of hydrogen, a halogen, a nitrile group, a cyano group, a nitro group, an amide group, a carbonyl group, ester group, a substituted or unsubstituted alkyl group, a substituted or unsubstituted alkylene group, a substituted or unsubstituted alkoxy group, a substituted or unsubstituted alkenyl group, a substituted or unsubstituted alkenylene group, a substituted or unsubstituted alkynyl group, a substituted or unsubstituted alkynylene group, a substituted or unsubstituted cycloalkyl group, a substituted or unsubstituted cycloalkylene group, a substituted or unsubstituted aryl group, and a substituted or unsubstituted arylene group, and Ar₁ is a substituted or unsubstituted arylene group, Ar₂ and Ar₃ are the same or different and are independently a substituted or unsubstituted aryl group, **characterised in that** at least one of A₁, A₃ and A₅ comprises N, and a substituent including A₆ to A₁₀ and a substituent including A₁₁ to A₁₅ are a quinolinyl group, or an isoquinolinyl group.

2. The compound for an organic photoelectric device of claim 1, wherein the compound comprises at least one of the following Chemical Formulae 18, 23, 28, 34, 38, 43, and 48:

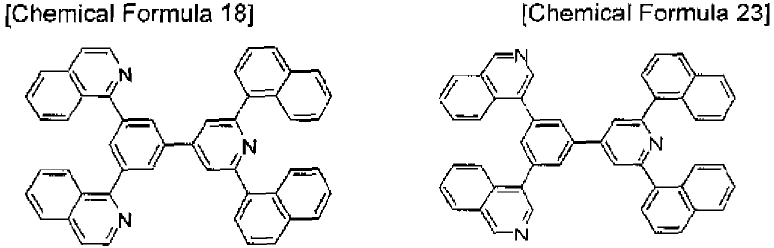

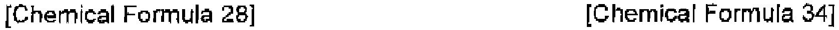

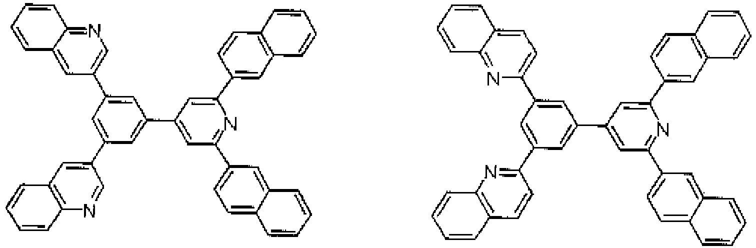

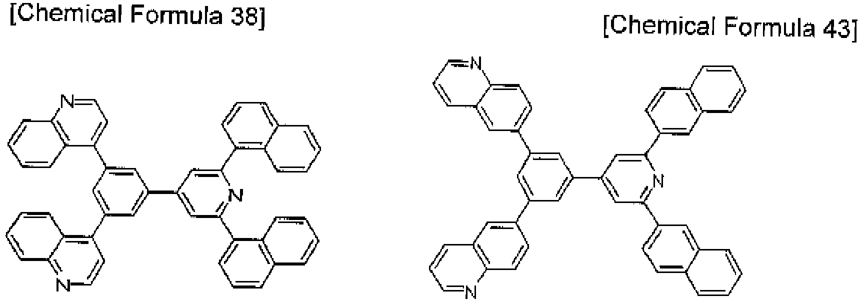

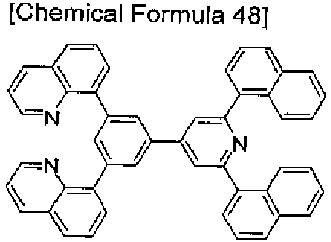

3. The compound for an organic photoelectric device of claim 1, wherein the compound comprises at least one of the following Chemical Formulae 19, 24, 29, 35, 39, 44, and 49:

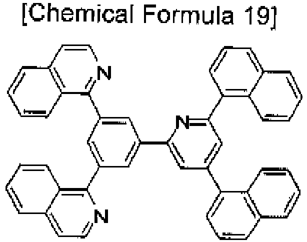

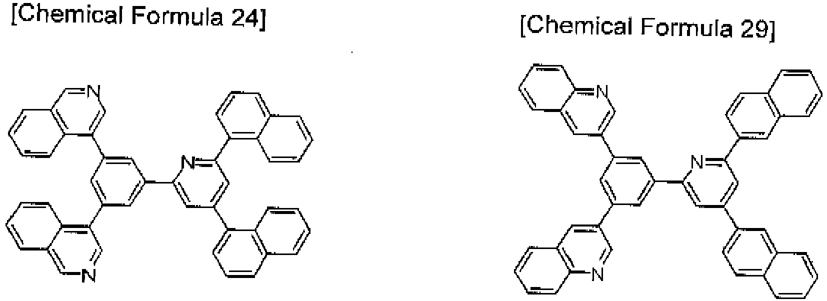

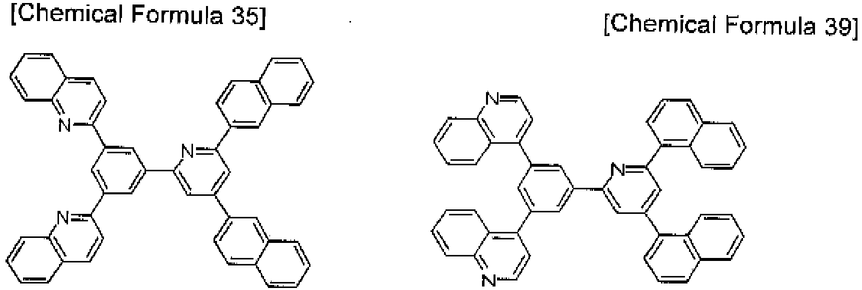

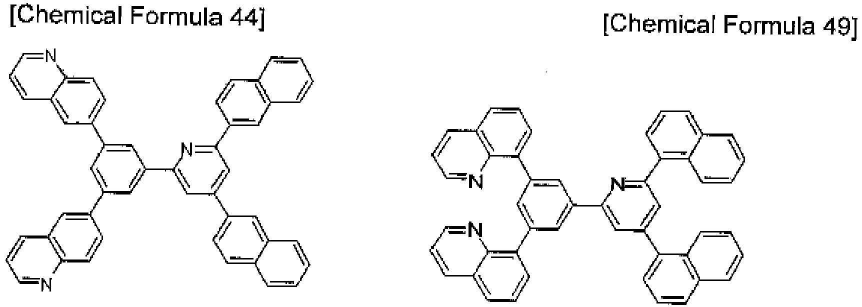

4. The compound for an organic photoelectric device of claim 1, wherein the compound comprises at least one of the following Chemical Formulae 20 to 22, 25 to 27, 30 to 33, 36, 37, 40 to 42, 45 to 47 and 50 to 52:

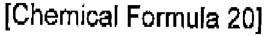

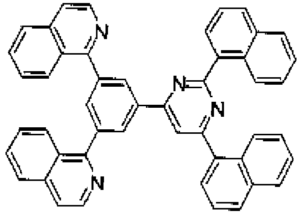

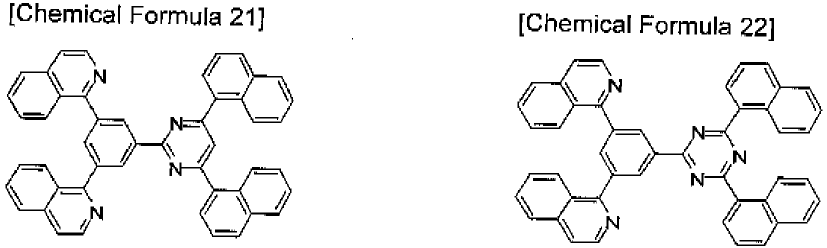

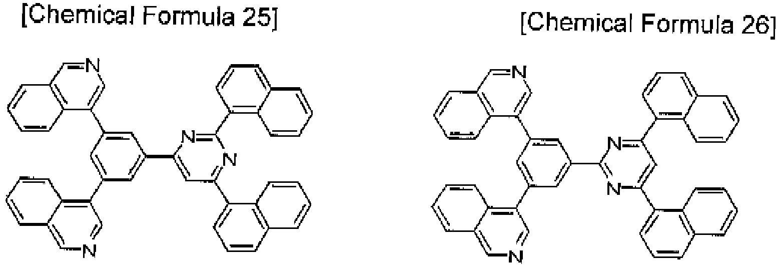

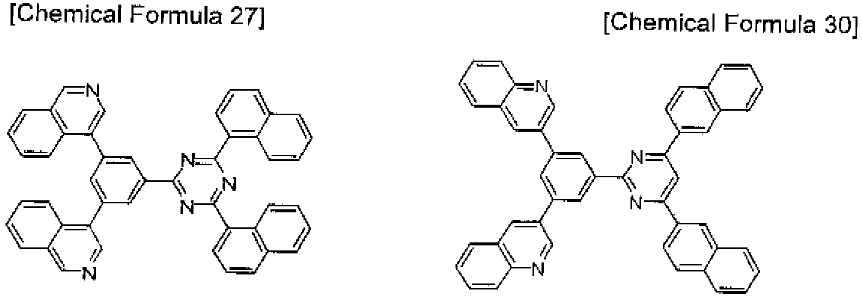

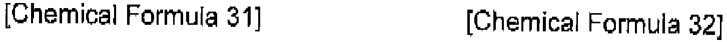

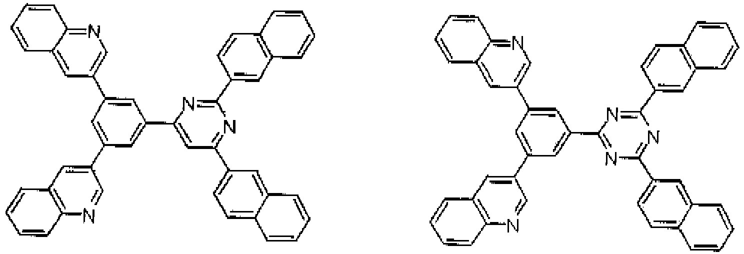

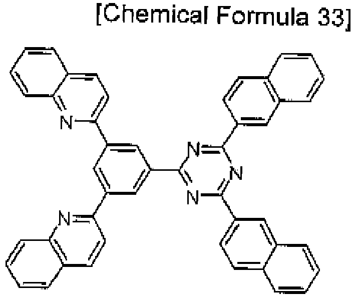

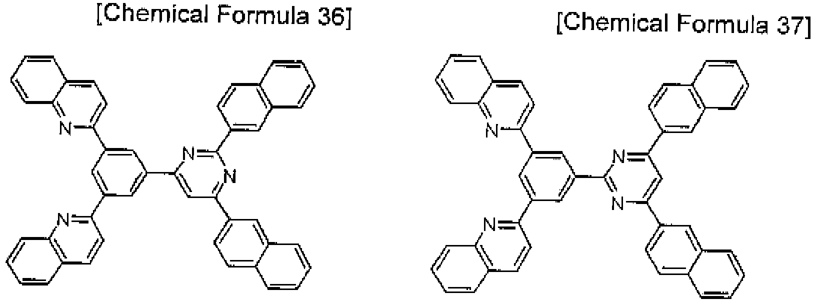

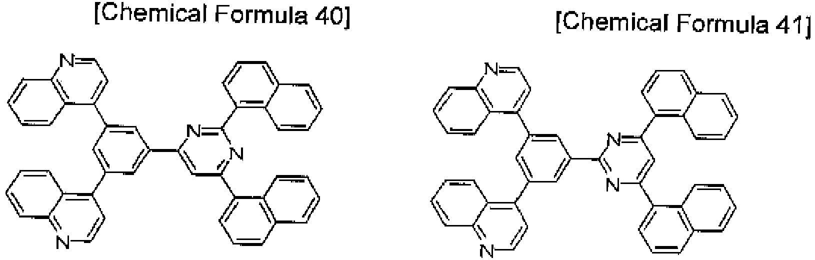

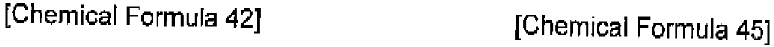

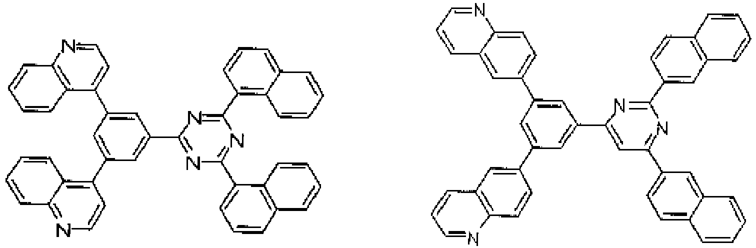

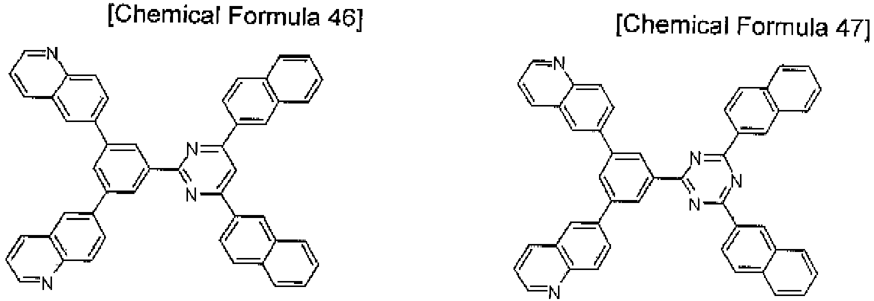

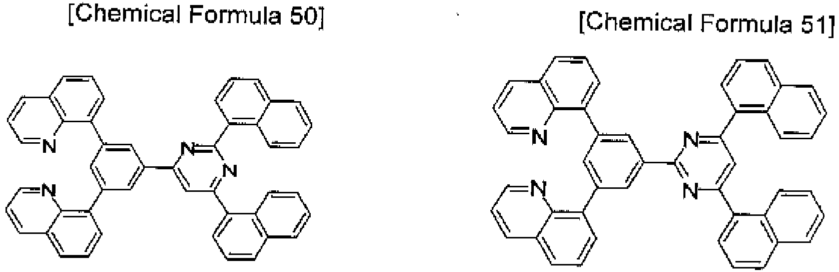

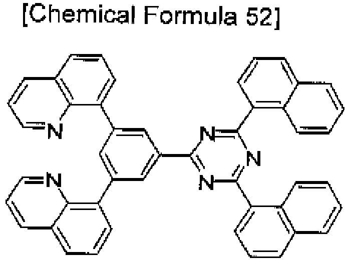

5. An organic photoelectric device, comprising
an anode, a cathode, and at least one of an organic thin layer between the anode and cathode,
wherein at least one of the organic thin layer comprises the compound for an organic photoelectric device of any one of claim 1 to claim 4.

6. A display device comprising the organic photoelectric device according to claim 5.

## Patentansprüche

1. Verbindung für eine organische photoelektrische Vorrichtung, wobei die Verbindung für eine organische photoelektrische Vorrichtung durch die folgende chemische Formel 2 dargestellt wird: 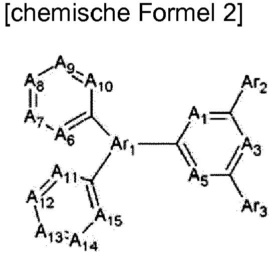 wobei in der chemischen Formel 2,
A₁, A₃, A₅, A₆ bis A₁₅ gleich oder verschieden sind und unabhängig aus der Gruppe bestehend aus CR₁, CR₃, CR₅, CR₆ bis CR₁₅, SiR₁, SiR₃, SiR₅, SiR₆ bis SiR₁₅ und N ausgewählt sind, wobei benachbarte Komponenten R₆ bis R₁₀ optional aneinander kondensiert sind, um einen kondensierten Ring zu bilden, oder benachbarte Komponenten R₁₁ bis R₁₅ optional aneinander kondensiert sind, um einen kondensierten Ring zu bilden,
vorausgesetzt, dass mindestens eine der Komponenten A₁, A₃ und A₅ ausgewählt ist aus der Gruppe bestehend aus SiR₁, SiR₃, SiR₅ und N, mindestens eine der Komponenten A₆ bis A₁₀ ausgewählt ist aus der Gruppe bestehend aus SiR₆ bis SiR₁₀ und N, oder mindestens ein Atom eines kondensierten Rings, der durch die benachbarten Komponenten R₆ bis R₁₀ gebildet wird, ein Heteroatom ist, und mindestens eine Komponente von A₁₁ bis A₁₅ ausgewählt ist aus der Gruppe bestehend aus SiR₁₁ bis SiR₁₅ und N, oder mindestens ein Atom eines kondensierten Rings, der durch die benachbarten Komponenten R₁₁ bis R₁₅ gebildet wird, ein Heteroatom ist;
R₁, R₃, R₅, R₆ bis R₁₅ gleich oder verschieden und jeweils unabhängig ausgewählt sind aus der Gruppe bestehend aus Wasserstoff, einem Halogen, einer Nitrilgruppe, einer Cyanogruppe, einer Nitrogruppe, einer Amidgruppe, einer Carbonylgruppe, einer Estergruppe, einer substituierten oder unsubstituierten Alkylgruppe, einer substituierten oder unsubstituierten Alkylengruppe, einer substituierten oder unsubstituierten Alkoxygruppe, einer substituierten oder unsubstituierten Alkenylgruppe, einer substituierten oder unsubstituierten Alkenylengruppe, einer substituierten oder unsubstituierten Alkinylgruppe, einer substituierten oder unsubstituierten Alkinylengruppe, einer substituierten oder unsubstituierten Cycloalkylgruppe, einer substituierten oder unsubstituierten Cycloalkylengruppe, einer substituierten oder unsubstituierten Arylgruppe und einer substituierten oder unsubstituierten Arylengruppe, und
Ar₁ eine substituierte oder unsubstituierte Arylengruppe ist, Ar₂ und Ar₃ gleich oder verschieden und unabhängig eine substituierte oder unsubstituierte Arylgruppe sind;
**dadurch gekennzeichnet, dass**
mindestens eine der Komponenten Ar₁, Ar₃ und Ar₅ N aufweist und ein Substituent, der A₆ bis A₁₀ enthält, und ein Substituent, der A₁₁ bis A₁₅ enthält, eine Chinolinylgruppe oder eine Isochinolinylgruppe ist.

2. Verbindung nach Anspruch 1, wobei die Verbindung mindestens eine der folgenden chemischen Formeln 18, 23, 28, 38, 43 und 48 aufweist:

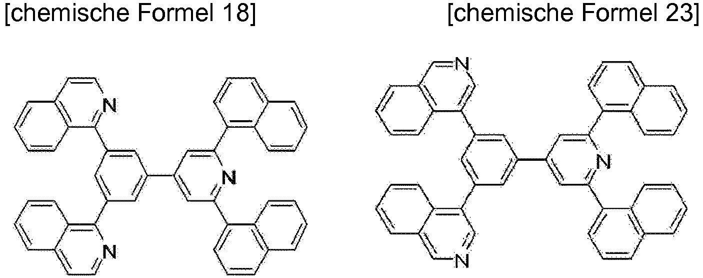

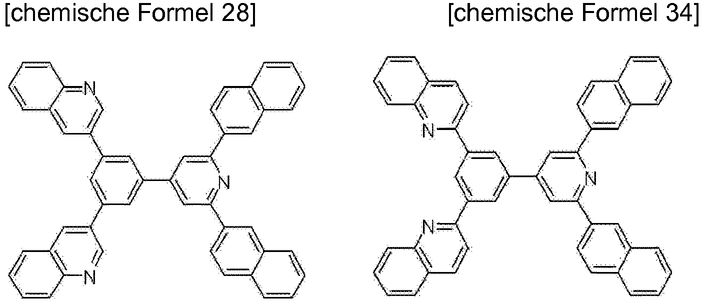

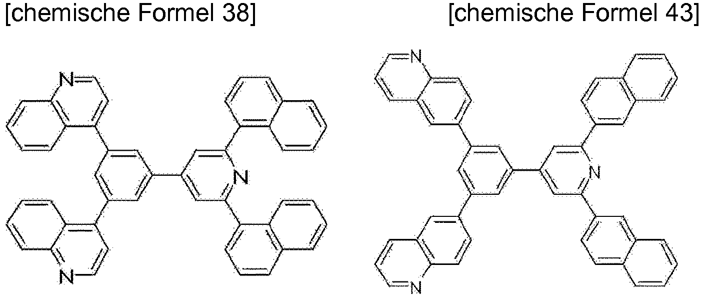

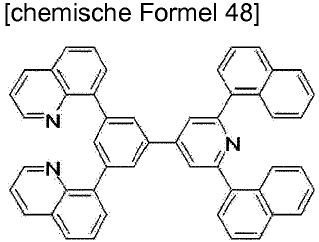

3. Verbindung nach Anspruch 1, wobei die Verbindung mindestens eine der folgenden chemischen Formeln 19, 24, 29, 35, 39, 44 und 49 aufweist:

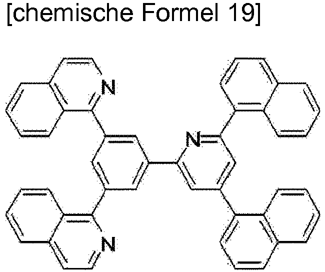

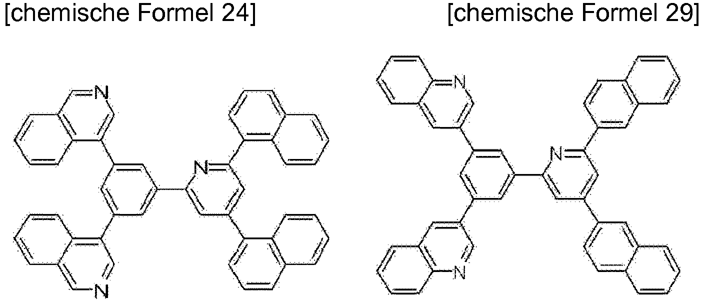

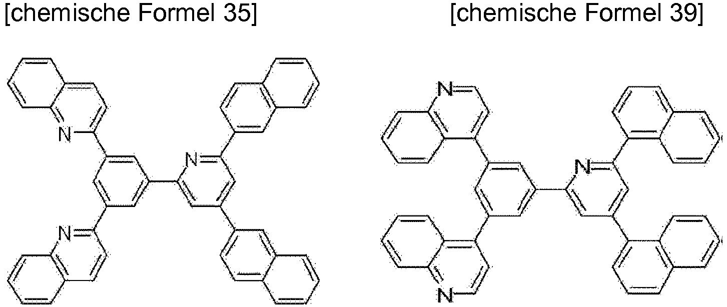

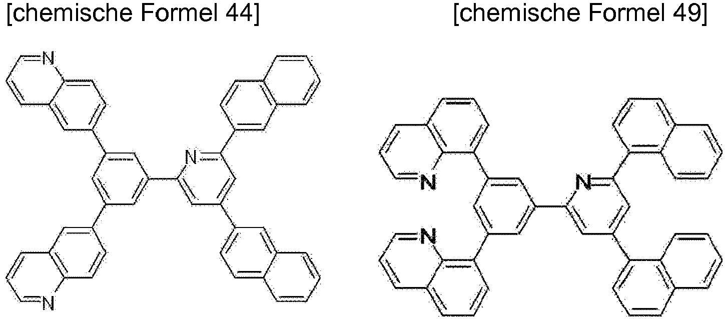

4. Verbindung nach Anspruch 1, wobei die Verbindung mindestens eine der folgenden chemischen Formeln 20 bis 22, 25 bis 27, 30 bis 33, 36, 37, 40 bis 42, 45 bis 47 und 50 bis 52 aufweist:

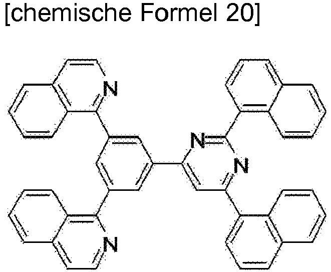

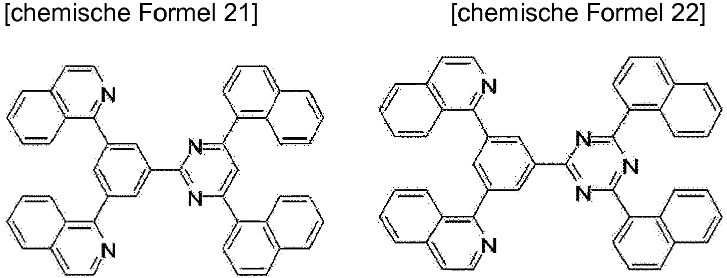

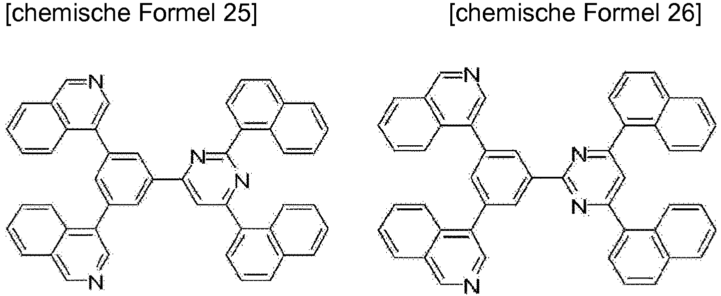

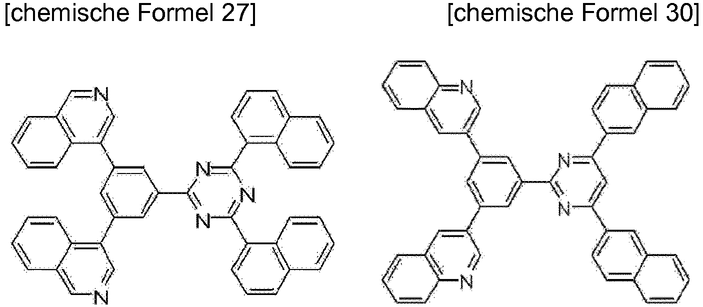

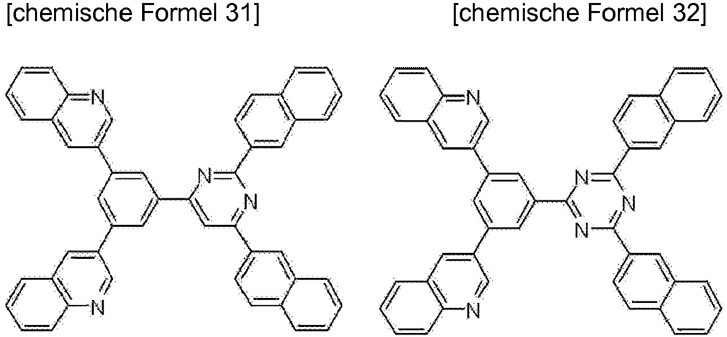

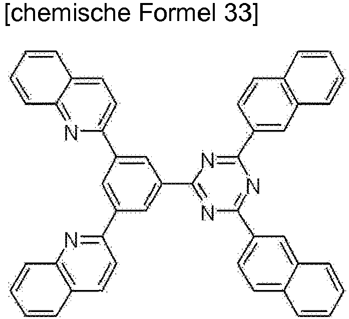

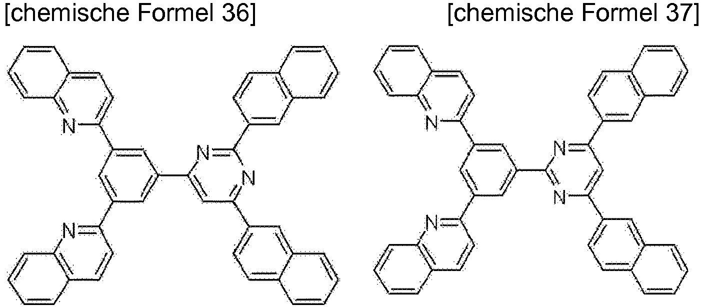

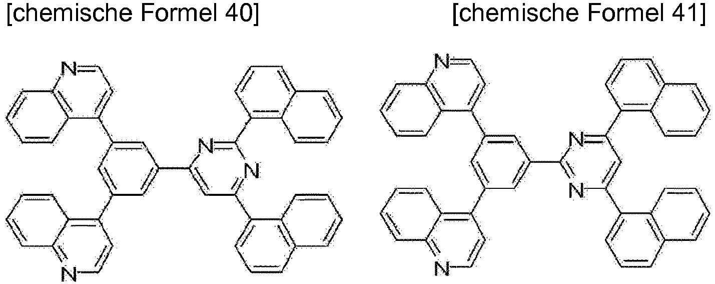

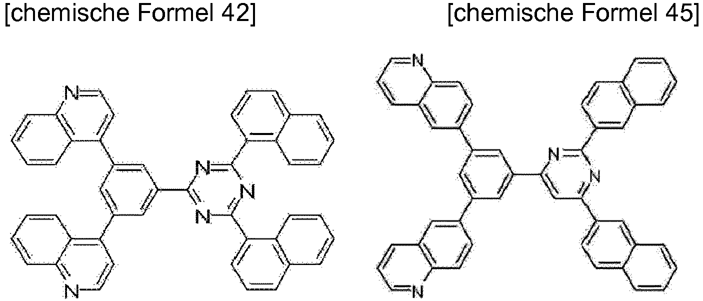

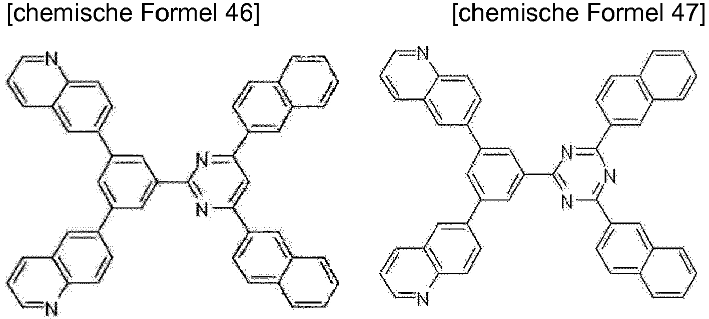

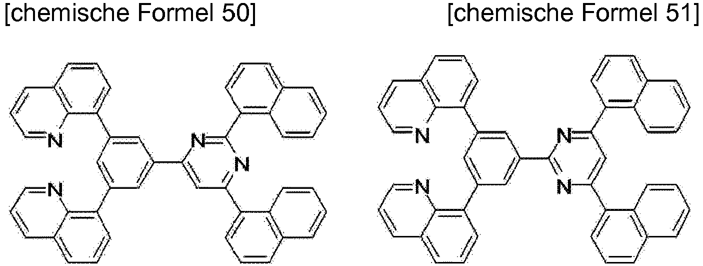

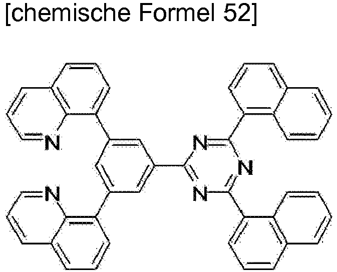

5. Anorganische photoelektrische Vorrichtung mit
einer Anode, einer Kathode und mindestens einer organischen Dünnschicht zwischen der Anode und der Kathode,
wobei mindestens eine der organischen Dünnschichten die Verbindung für eine organische photoelektrische Vorrichtung nach einem der Ansprüche 1 bis 4 aufweist.

6. Displayvorrichtung mit der organischen photoelektrischen Vorrichtung nach Anspruch 5.

## Revendications

1. Composé pour un dispositif photoélectrique organique, dans lequel le composé pour un dispositif photoélectrique organique est représenté par la Formule Chimique 2 suivante : 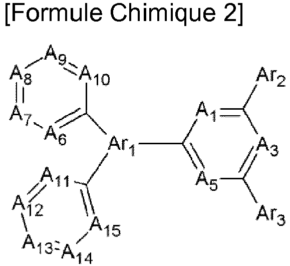 dans lequel, dans la Formule Chimique 2,
A₁, A₃, A₅, A₆ à A₁₅ sont identiques ou différents et sont choisis indépendamment dans le groupe consistant en CR₁, CR₃, CR₅, CR₆ à CR₁₅, SiR₁, SiR₃, SiR₅, SiR₆, à SiR₁₅, et N, dans lequel les R₆ à R₁₀ adjacents sont facultativement fusionnés l'un à l'autre pour former un cycle fusionné, ou les R₁₁ à R₁₅ adjacents sont facultativement fusionnés l'un à l'autre pour former un cycle fusionné,
à condition que, au moins l'un de A₁, A₃ et A₅ soit choisi dans le groupe consistant en SiR₁, SiR₃, SiR₅ et N, au moins l'un de A₆ à A₁₀ soit choisi dans le groupe consistant en SiR₆ à SiR₁₀ et N ; ou au moins l'un des atomes d'un cycle fusionné formé par les R₆ à R₁₀ adjacents est un hétéroatome, et au moins l'un de A₁₁ à A₁₅ est choisi dans le groupe consistant en SiR₁₁ à SiR₁₅ et N ; ou au moins l'un des atomes d'un cycle fusionné formé par les R₁₁ à R₁₅ adjacents est un hétéroatome,
R₁, R₃, R₅, R₆ à R₁₅ sont identiques ou différents et sont chacun choisis indépendamment dans le groupe constitué par l'hydrogène, un halogène, un groupe nitrile, un groupe cyano, un groupe nitro, un groupe amide, un groupe carbonyle, un groupe ester, un groupe alkyle substitué ou non substitué, un groupe alkylène substitué ou non substitué, un groupe alcoxy substitué ou non substitué, un groupe alcényle substitué ou non substitué, un groupe alcénylène substitué ou non substitué, un groupe alcynyle substitué ou non substitué, un groupe alcynylène substitué ou non substitué, un groupe cycloalkyle substitué ou non substitué, un groupe cycloalkylène substitué ou non substitué, un groupe aryle substitué ou non substitué, et un groupe arylène substitué ou non substitué, et
Ar₁ représente un groupe arylène substitué ou non substitué, Ar₂ et Ar₃ sont identiques ou différents et représentent indépendamment un groupe aryle substitué ou non substitué
**caractérisé en ce que**
au moins l'un de A₁, A₃ et A₅ comprend N, et un substituant comprenant A₆ à A₁₀ et un substituant comprenant A₁₁ à A₁₅ sont un groupe quinolinyle ou un groupe isoquinolinyle.

2. Composé pour un dispositif photoélectrique organique selon la revendication 1, dans lequel le composé comprend au moins l'une des Formules Chimiques 18, 23, 28, 34, 38, 43, et 48 suivantes :

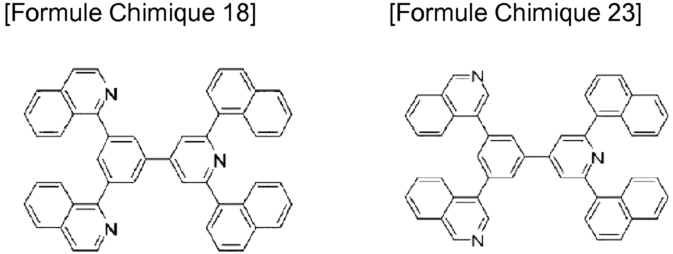

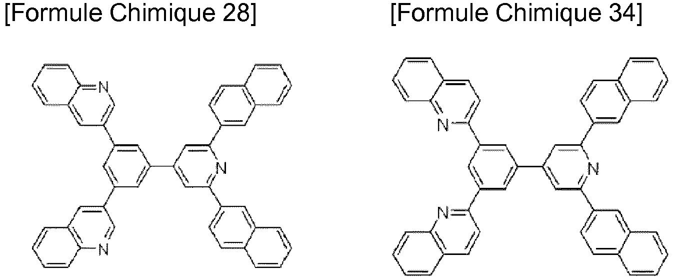

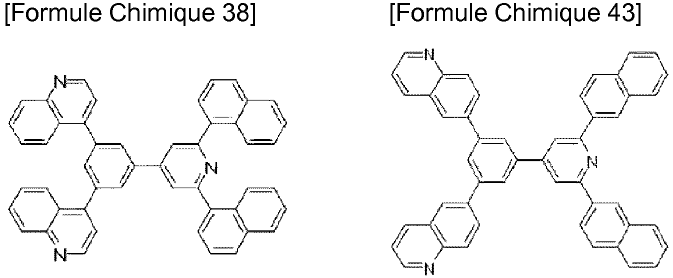

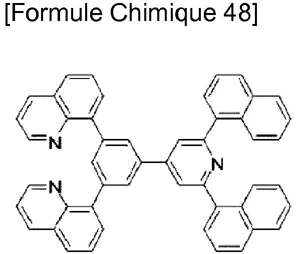

3. Composé pour un dispositif photoélectrique organique selon la revendication 1, dans lequel le composé comprend au moins l'une des Formules Chimiques 19, 24, 29, 35, 39, 44, et 49 suivantes :

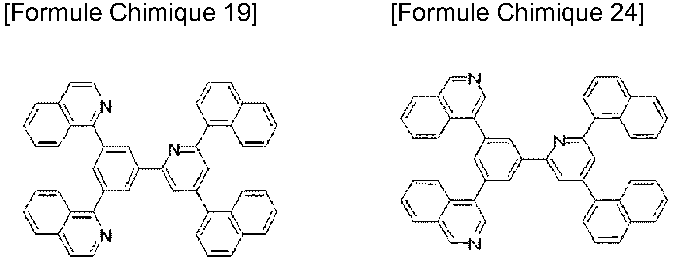

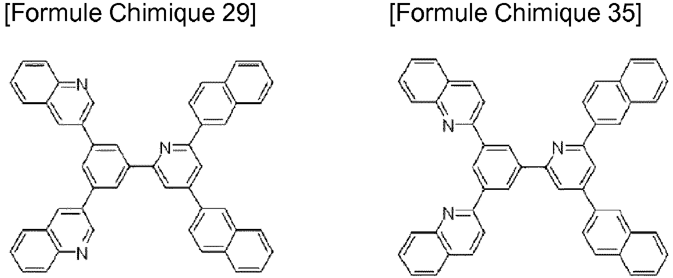

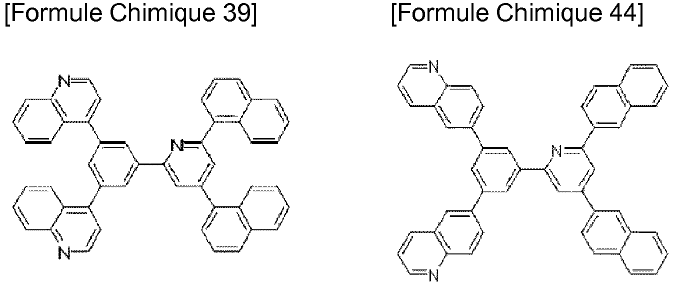

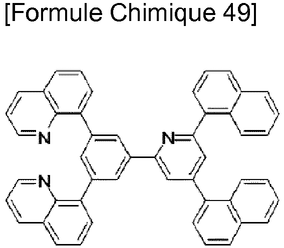

4. Composé pour un dispositif photoélectrique organique selon la revendication 1, dans lequel le composé comprend au moins l'une des Formules Chimiques 20 à 22, 25 à 27, 30 à 33, 36, 37, 40 à 42, 45 à 47 et 50 À 52 :

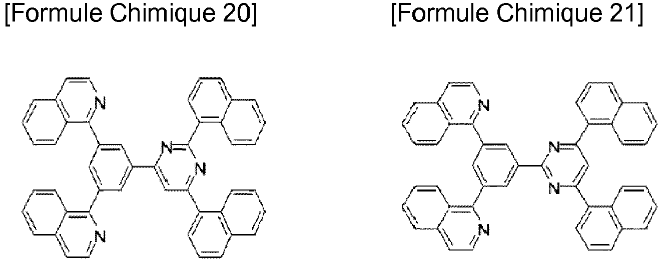

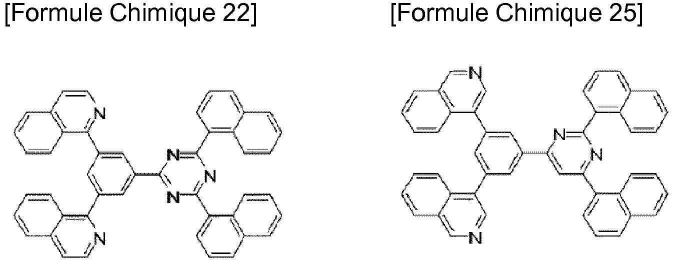

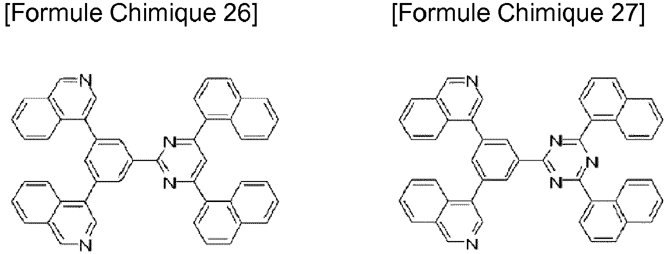

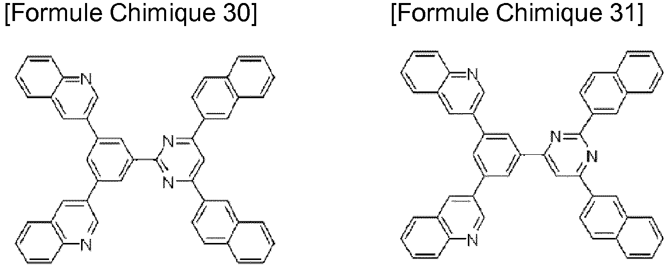

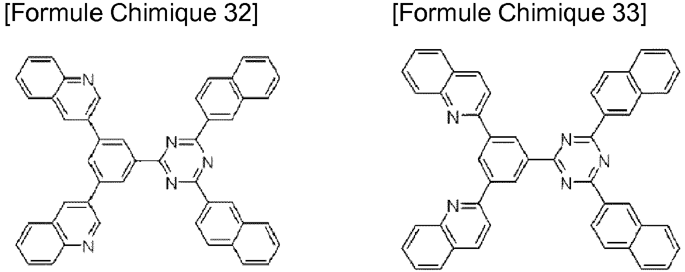

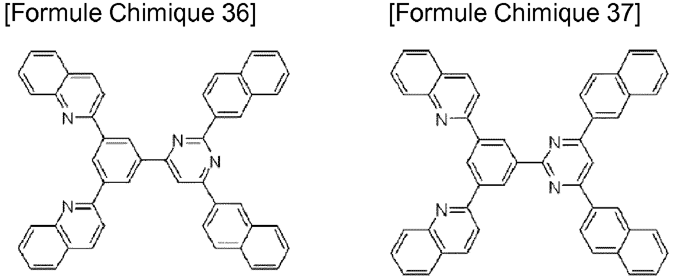

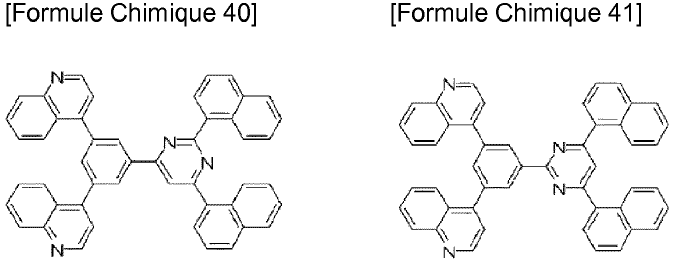

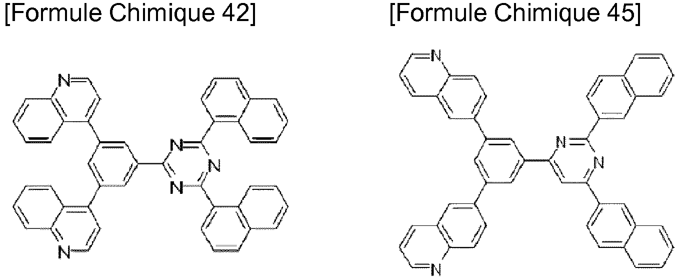

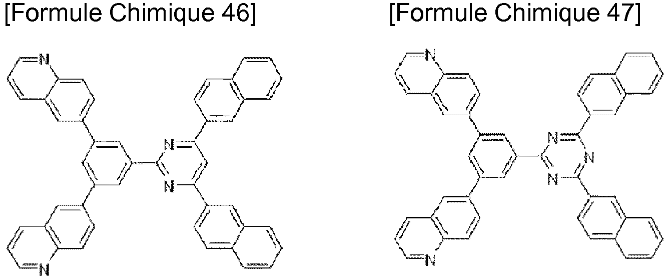

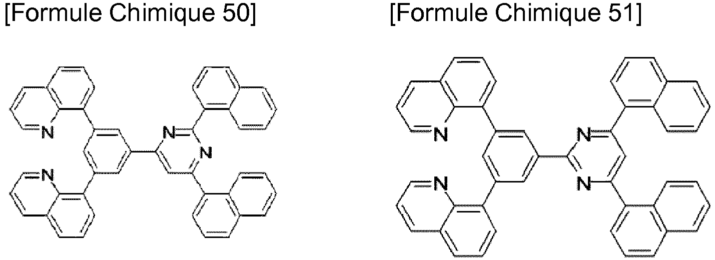

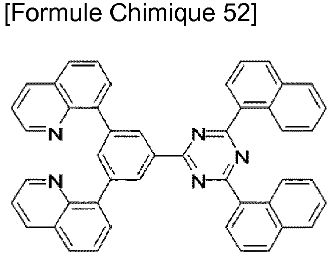

5. Dispositif photoélectrique organique comprenant :
une anode, une cathode et au moins une d'une couche mince organique entre l'anode et la cathode,
dans lequel au moins l'une de la couche mince organique comprend le composé pour un dispositif photoélectrique organique selon l'une quelconque des revendications 1 à 4.

6. Dispositif d'affichage comprenant le dispositif photoélectrique organique selon la revendication 5.
